# EUROPÄISCHE PATENTSCHRIFT

(11) **EP 1 713 136 B1**
(45) Veröffentlichungstag und Bekanntmachung des Hinweises auf die Patenterteilung: **12.12.2007**
(21) Anmeldenummer: 05008105.8
(22) Anmeldetag: 13.04.2005
(51) Int. Cl.: H01L 51/52

(54) **Anordnung für eine organische Leuchtdiode vom pin-Typ und Verfahren zum Herstellen**
Device for organic light emitting diode of pin-type and method for its manufacture
Dispositif pour diode électroluminescente organique et méthode de sa fabrication

(43) Veröffentlichungstag der Anmeldung: 18.10.2006
(60) Teilanmeldung: 07005048.9
(73) Patentinhaber: Novaled AG, 01307 Dresden (DE)
(72) Erfinder: Hofmann, Dipl. Phys. Michael, 01187 Dresden (DE); Birnstock , Dr. Jan, 01187 Dresden (DE); Blochwitz-Nimoth, Dr. Jan, 01097 Dresden (DE); Werner , Dr. Ansgar, 01277 Dresden (DE); Pfeiffer , Dr. Martin, 01139 Dresden (DE); Harada , Kentaro, 01307 Dresden (DE)
(74) Vertreter: Bittner, Thomas L.

(56) Entgegenhaltungen:
- EP-A- 1 017 118
- EP-A- 1 030 383
- EP-A- 1 511 094
- US-A- 5 093 698
- US-A1- 2004 251 816
- D'ANDRADE B W ET AL: "OPERATIONAL STABILITY OF ELECTROPHOSPHORESCENT DEVICES CONTAINING P AND N DOPED TRANSPORT LAYERS" APPLIED PHYSICS LETTERS, AIP, AMERICAN INSTITUTE OF PHYSICS, MELVILLE, NY, US, Bd. 83, Nr. 19, 10. November 2003 (2003-11-10), Seiten 3858-3860, XP001191660 ISSN: 0003-6951
- HE G ET AL: "HIGH-EFFICIENCY AND LOW-VOLTAGE P-I-N ELECTROPHOSPHORESCENT ORGANIC LIGHT-EMITTING DIODES WITH DOUBLE-EMISSION LAYERS" APPLIED PHYSICS LETTERS, AIP, AMERICAN INSTITUTE OF PHYSICS, MELVILLE, NY, US, Bd. 85, Nr. 17, 25. Oktober 2004 (2004-10-25), Seiten 3911-3913, XP008049614 ISSN: 0003-6951
- ZHOU X ET AL: "LOW-VOLTAGE INVERTED TRANSPARENT VACUUM DEPOSITED ORGANIC LIGHT-EMITTING DIODES USING ELECTRICAL DOPING" APPLIED PHYSICS LETTERS, AIP, AMERICAN INSTITUTE OF PHYSICS, MELVILLE, NY, US, Bd. 81, Nr. 5, 29. Juli 2002 (2002-07-29), Seiten 922-924, XP001133200 ISSN: 0003-6951

## Beschreibung

Die Erfindung bezieht sich auf eine Anordnung für eine organische Leuchtdiode (OLED) vom pin-Typ und ein Verfahren zum Herstellen.

### Stand der Technik

Organische Leuchtdioden sind seit der Demonstration niedriger Arbeitsspannungen von Tang et al. (vgl. C.W. Tang et al.: Appl. Phys. Lett. 51 (12), 913 (1987)) aussichtsreiche Kandidaten für die Realisierung von neuartigen Beleuchtungs- oder Anzeigeelementen. Sie umfassen eine Folge dünner Schichten aus organischen Materialien, welche bevorzugt im Vakuum aufgedampft oder in ihrer polymeren Form aufgeschleudert werden. Nach elektrischer Kontaktierung mittels Metallschichten bilden sie vielfältige elektronische oder optoelektronische Bauelemente, beispielsweise Dioden, Leuchtdioden, Photodioden und Transistoren, die mit ihren Eigenschaften den etablierten Bauelementen auf der Basis anorganischer Schichten Konkurrenz machen.

Im Fall der organischen Leuchtdioden wird mittels Injektion von Ladungsträgern, nämlich Elektronen von der einen und Löcher von der anderen Seite, aus den Kontakten in die anschließenden organischen Schichten infolge einer äußeren angelegten Spannung, der folgenden Bildung von Exzitonen (Elektron-Loch-Paare) in einer aktiven Zone und der strahlenden Rekombination dieser Exzitonen, Licht erzeugt und von der Leuchtdiode emittiert.

Der Vorteil solcher Bauelemente auf organischer Basis gegenüber den konventionellen Bauelementen auf anorganischer Basis, zum Beispiel Halbleiter wie Silizium, Galliumarsenid, besteht darin, dass es möglich ist, sehr großflächige Elemente herzustellen, also große Anzeigeelemente (Bildschirme, Screens). Die organischen Ausgangsmaterialien sind gegenüber den anorganischen Materialien relativ preisgünstig. Obendrein können diese Materialien aufgrund ihrer gegenüber anorganischen Materialien geringen Prozeßtemperatur auf flexible Substrate aufgebracht werden, was eine ganze Reihe von neuartigen Anwendungen in der Display- und Beleuchtungstechnik eröffnet.

In dem Dokument US 5,093,698 wird eine organische Leuchtdiode vom pin-Typ beschrieben, bei der es sich um eine organische Leuchtdiode mit dotierten Ladungsträgertransportschichten handelt. Insbesondere kommen drei organische Schichten zur Anwendung die sich zwischen zwei Elektroden befinden. N-artig und p-artig dotierte Schichten verbessern darin die Ladungsträgerinjektion und den Transport sowohl von Löchern und Elektronen in der entsprechend dotierten Schicht. Die vorgeschlagene Struktur besteht mithin aus mindestens drei Schichten mit mindestens fünf Materialien.

Die Energieniveaus HOMO *(" Highest Occupied Molecular Orbital")* und LUMO *(" Lowest Unoccupied Molecular Orbital* ") sind bevorzugt so gewählt, dass beide Sorten von Ladungsträgern in der Emissionszone "gefangen" werden, um eine effiziente Rekombination von Elektronen und Löchern zu gewährleisten. Die Beschränkung der Ladungsträger auf die Emissionszone wird durch eine geeignete Wahl der Ionisationspotentiale bzw. Elektronenaffinitäten für die Emissionsschicht bzw. die Ladungsträgertransportschicht realisiert, wie später erläutert wird.

Die aus dem Dokument US 5,093,698 bekannte Bauelementstruktur führt zu einer stark verbesserten Ladungsträgerinjektion aus den Kontakten in die organischen Schichten. Die hohe Leitfähigkeit der dotierten Schichten vermindert zudem den dort auftretenden Spannungsabfall beim Betrieb der OLED. Dotierte Bauelemente sollten deshalb bei einer gewünschten Leuchtdichte deutlich geringere Betriebsspannungen als vergleichbare undotierte Strukturen benötigen. Hierauf aufbauende Untersuchungen solcher dotierter Bauelemente ergaben jedoch, daß dies nicht zwangsläufig der Fall ist. In der ursprünglichen pin-Struktur können sowohl Exziplexbildung als auch so genannte Lumineszenzlöschung (Quenching-Effekte) nicht ausgeschlossen werden, was sich negativ auf die Quantenausbeute der Elektrolumineszenz auswirkt. Lumineszenzlöschung tritt vor allem dann auf, wenn sich p- oder n-Dotanden in unmittelbarer Nähe, d.h. in der zur Emissionszone angrenzenden Organikschicht, befinden.

Im Dokument DE 100 58 578 C2 wurden aus diesen Gründen Blockschichten zwischen der zentralen Emissionsschicht und mindestens einer Ladungsträgertransportschicht eingefügt. Hierbei sind die Ladungsträgertransportschichten ebenfalls entweder mit Akzeptoren oder Donatoren dotiert. Beschrieben ist, wie die Energieniveaus der Blockmaterialien zu wählen sind, um Elektronen und Löcher in der Licht emittierenden Zone anzureichern. Somit ermöglicht die bekannte Struktur tatsächlich hohe Effizienzen, da die zusätzlichen Zwischenschichten auch als Pufferzone zu vormals möglichen Quenching-Effekten an Dotandenstörstellen wirken.

Eine Lumineszenzlöschung kann durch mehrere Effekte hervorgerufen sein. Ein möglicher Mechanismus ist als Exziplexbildung bekannt. In einem solchen Fall befinden sich Löcher und Elektronen, die eigentlich miteinander auf einem Emittermolekül in der Emissionszone rekombinieren sollen, auf zwei unterschiedlichen Molekülen an einer der Grenzflächen zur Emissionsschicht. Dieser sogenannte Exziplex-Zustand kann als ein Charge-Transfer-Exziton verstanden werden, wobei die beteiligten Moleküle unterschiedlicher Natur sind. Bei ungeeigneter Wahl der Materialien für Block- bzw. Emissionsschicht ist dieser Exziplex der energetisch niedrigstmögliche angeregte Zustand, so dass die Energie des eigentlich erwünschten Exzitons auf einem Emittermolekül in diesen Exziplex-Zustand übertragen werden kann. Das führt zu einer Verringerung der Quantenausbeute der Elektrolumineszenz und damit der OLED. In einigen Fällen wird auch die rotverschobene Elektrolumineszenz des Exziplexes beobachtet, die dann aber in der Regel durch sehr geringe Quantenausbeuten gekennzeichnet ist.

Weitere in OLEDs auftretende Mechanismen der Lumineszenzlöschung entstehen durch Wechselwirkung von Exzitonen mit geladenen oder ungeladenen Dotiermolekülen einerseits und / oder mit Lädungsträgern andererseits. Der erste Mechanismus wird mittels Einsatz von undotierten Blockschichten aufgrund der kurzen Reichweite der Wechselwirkung effektiv unterdrückt. Da Ladungsträger bei Betrieb der OLED zwangsläufig in und in der Nähe der Emissionszone auftreten müssen, kann hier eine Optimierung nur dahingehend erfolgen, dass eine Anhäufung von Ladungsträgern zum Beispiel an einer Banddiskontinuität vermieden wird. Dies stellt insbesondere Anforderungen an die Wahl der Bandlagen für Blockmaterial und Emitter, um hier Barrieren für die Ladungsträgerinjektion und damit eine Anhäufung von Ladungsträgern zu vermeiden.

Eine pin-Struktur gemäß dem Dokument DE 100 58 578 C2 umfasst bereits mindestens fünf Einzelschichten mit mehr als sechs verschiedenen organischen Materialien, was der Tatsache geschuldet ist, dass die Funktionalität einer jeden Einzelschicht eng mit den spezifischen Energieniveaus verknüpft ist, wie dies in dem Dokument DE 100 58 578 C2 näher erläutert ist.

Einen ersten Schritt zu Vereinfachung bieten BPhen/BPhen:Cs Schichtsequenzen (vgl. He et al.: Appl. Phys. Lett., 85 (17), 3911 (2004)). Dieses System verwendet das gleiche Matrixmaterial, nämlich Bphen, sowohl in der Elektronentransportschicht als auch für die direkt angrenzende Löcherblockschicht. Bei diesem bekannten System ist aber die mögliche Exziplexbildung aufgrund eines maßgeblichen Energieniveauunterschiedes zwischen LUMO vom BPhen und dem HOMO der für die Emissionszone benutzten Matrix nicht verhindert. Tatsächlich wird über eine Verbesserung des Bauelements mittels Wahl von TAZ für die Löcherblockschicht berichtet. Die Schichtsequenz BPhen/BPhen:Cs entspricht demnach nicht zur Vereinfachung von Schichtstrukturen unter Erhalt der Effizienz der Bauelemente, die mit Hilfe einer gezielten Auswahl der betreffenden Materialien erfolgt. Insbesondere ist das bekannte System nicht kompatibel zur dort gewählten Kombination von Emittermaterialien. Weiterhin beinhaltet die von He et al. beschriebene Struktur mindestens vier Matrixmaterialien.

Ferner ist eine Struktur bekannt, in der Emissionsschicht und eine Ladungsträgertransportschicht aus demselben organischen Matrixmaterial bestehen (vgl. J. Kido, Proc. 1st Int. Display Manufacturing Conference IDMC 2000, Seoul, 2000). Hier ist ein organisches Licht emittierendes Bauelement erläutert, dass eine Alq3-Schicht als Emissionsschicht verwendet, an die wiederum eine Li-dotierte Alq3-Elektronentransportschicht angrenzt. Diese Sequenz wird nicht in eine pin-OLED-Struktur eingebettet, in der sowohl Akzeptoren in der Löchertransportschicht als auch Donatoren in der Elektronentransportschicht vorkommen.

### Die Erfindung

Aufgabe der Erfindung ist es, eine Anordnung für eine organische Leuchtdiode vom pin-Typ und ein Verfahren zum Herstellen anzugeben, bei denen der Aufbau des Stapels organischer Schichten vereinfacht ist.

Diese Aufgabe wird durch eine Anordnung für eine organische Leuchtdiode vom pin-Typ nach Anspruch 1 sowie ein Verfahren zum Herstellen eines Stapels mit organischen Schichten für eine organische Leuchtdiode vom pin-Typ nach Anspruch 18 gelöst.

Vorteilhafte Ausgestaltungen der Erfindung sind Gegenstand von abhängigen Unteransprüchen.

Nach einem Aspekt der Erfindung ist eine Anordnung für eine organische Leuchtdiode vom pin-Typ mit einer Elektrode und einer Gegenelektrode und einem Stapel mit organischen Schichten zwischen der Elektrode und der Gegenelektrode geschaffen, wobei der Stapel mit den organischen Schichten eine k (k=1, 2, 3, ...) organische Matrixmaterialien umfassende Emissionsschicht, eine dotierte Ladungsträgertransportschicht, die zwischen der Elektrode und der Emissionsschicht angeordnet ist, eine weitere dotierte Ladungsträgertransportschicht, die zwischen der Gegenelektrode und der Emissionsschicht angeordnet ist, und mindestens eine Blockschicht umfasst, die zwischen einer der dotierten Ladungsträgertransportschichten und der Emissionsschicht angeordnet ist. Die organischen Schichten des Stapels sind mittels n (n ≤ k+2) organischen Matrixmaterialien gebildet, wobei die n organischen Matrixmaterialien die k organischen Matrixmaterialien der Emissionsschicht umfassen, und die dotierte Ladungsträgertransportschicht, die Blockschicht und die weitere dotierte Ladungsträgertransportschicht aus einem ersten organischen Matrixmaterial sind, welches von den n organischen Matrixmaterialen umfasst ist.

Nach einem weiteren Aspekt der Erfindung ist ein Verfahren zum Herstellen eines Stapels mit organischen Schichten für eine organische Leuchtdiode vom vereinfachten pin-Typ geschaffen, wobei ein organisches Matrixmaterial mit Hilfe einer Abscheidungsvorrichtung prozessiert wird. Dieses organische Matrixmaterial wird für mehrere organische Schichten des Stapels verwendet.

Ein organisches Matrixmaterial im Sinne der Erfindung ist jedes organische Wirtsmaterial, dem weitere Materialien, zum Beispiel Dotanden oder Emitterstoffe, typischerweise in den molaren Konzentrationen 1:100 000 bis 5:1 beigemischt werden können (Dotierung). Des weiteren wird der alleinige Bestandteil einer undotierten Schicht, zum Beispiel in Blockschichten, als Matrix bezeichnet. Als Dotanden für Emissionsschichten kommen fluoreszente oder phosphoreszente Emissionsmaterialien in Frage. Ferner gibt es auch Emissionsschichten, die ohne Dotierung Licht emittieren - in diesem Fall ist die Matrix der Emitter.

Die vereinfachten Schichtanordnungen für OLEDs vom pin-Typ weisen keine relevanten Nachteile hinsichtlich der üblichen Kenndaten auf und sind in dieser Hinsicht gleichwertig mit den bekannten komplex aufgebauten Strukturen. Leuchtdioden unter Verwendung solcher Schichtanordnungen weisen im Bereich der geforderten Helligkeit eine hohe Effizienz auf.

Die neuen Schichtanordnungen für OLEDs vom pin-Typ sind das Ergebnis umfangreicher Forschungsanstrengungen. Es ist gelungen, verschiedene, teils antagonistisch wirkende Anforderungen an die Eigenschaften der Materialien in dem Stapel organischer Schichten dahingehend zu optimieren, dass sowohl einfache als auch effiziente pin-OLED Strukturen realisiert werden können. Im Vergleich zu herkömmlichen organischen Leuchtdioden mit undotierten Ladungsträgertransportschichten ist bei organischen Leuchtdioden vom pin-Typ wegen der vorgesehenen Dotierung der Ladungsträgertransportschichten die Vielfältigkeit der unterschiedlichen Anforderungen an die verwendeten Matrixmaterialien wesentlich komplexer.

Ein Vorteil der Erfindung besteht darin, dass die Realisierung von Schichtanordnungen für OLEDs vom pin-Typ ermöglicht ist, die aus weniger organischen Matrixmaterialien bestehen als herkömmliche Schichtanordnungen. In einer vereinfachten Bauelementstrukturierung wird die Anzahl der verwendeten organischen Matrixmaterialien und der verwendeten Schichten begrenzt, indem ein und dasselbe organische Matrixmaterial für mehrere funktionelle Schichten verwendet wird. Dieser Ansatz erleichtert die Qualitätssicherung aufgrund einfacher Prozessierbarkeit und zuverlässigerer Herstellung von OLED-Bauelementen. Außerdem können Investitions- und Verbrauchskosten für Fertigungsanlagen minimiert werden.

Neben der wesentlich vereinfachten Prozessierung, ist auch die limitierte Anzahl von benötigten Materialien ein Vorteil der Erfindung. Darüber hinaus wird die Fertigung vereinfacht, da eine Verringerung der Anzahl der zur Schichtabscheidung benötigten Quellen möglich ist. Wenn mehrere aufeinander folgende organische Schichten durch ein und dasselbe organische Matrixmaterial gebildet werden, vereinfacht sich die Fertigung. Beispielsweise kann in einer bevorzugten Ausführungsform die Verdampfungsquelle für dieses Matrixmaterial kontinuierlich betrieben werden, wobei jeweils nur kurzzeitig die Quellenabschattung der Quellen für die Zusatzstoffe geöffnet werden muss.

Bestehen in einer Ausführungsform zum Beispiel in einer Schichtstruktur die Emissionsschicht, die Blockschicht und die Ladungsträgertransportschicht aus einem festgelegten Matrixmaterial, wird eine Quelle für das Matrixmaterial und jeweils eine Quelle für den Emitterdotanden und den elektrischen Dotanden benötigt. Die Fertigung der Schichtstruktur kann dann so erfolgen, dass bei laufendem Betrieb der Quelle für das organische Matrixmaterial zunächst die Quelle der Emitterdotanden geöffnet und dann zur Ausbildung der Blockschicht wieder abgeschattet wird und schließlich zur Abscheidung der Ladungsträgertransportschicht die Quelle des elektrischen Dotanden geöffnet wird. Diese Vorteile kommen beispielsweise bei der Fertigung mittels konventioneller thermischer Verdampfung im Hochvakuum als auch bei der Abscheidung von Schichten mit Hilfe der Methode *"Organic Vapor Phase Deposition"* (OVPD) (vgl. M. Baldo et al., Adv. Mater. 10 (18), 1505 (1998)) zum Tragen.

Mit verschiedenen bevorzugten Ausführungsformen der Erfindung kann erreicht werden, dass die Gesamtanzahl n der beim Herstellen des Stapels organischer Schichten verwendeten organischen Matrixmaterialien weiter gesenkt werden kann, so dass n ≤ k+1 oder sogar n=k gilt, wenn k (k=1, 2, 3, ...) die Anzahl der in der Emissionsschicht verwendeten organischen Matrixmaterialien ist.

### Beschreibung von Bauelementen

Im folgenden werden Bauelementen unter Bezugnahme auf die Figuren der Zeichnung näher erläutert. Hierbei zeigen:
- Fig. 1: eine schematische Darstellung einer Schichtanordnung für ein Licht emittierendes Bauelement mit Mehrfachschichten;

- Fig. 2A bis 2C: schematische Darstellungen von Energieniveaus für eine Anordnung orga-nischer Schichten, bei dem zumindest zwei benachbarte Schichten aus dem gleichen organischen Matrixmaterial sind;
- Fig. 3A und 3B: eine grafische Darstellung von Kenndaten für die Stromdichte und die Leuchtdichte sowie die Stromeffizienz und die Leistungseffizienz eines Bauelements auf Basis einer Struktur nach einer Ausführungsform c');
- Fig. 4A und 4B: eine grafische Darstellung von Kenndaten für die Stromdichte und Leuchtdichte sowie die Stromeffizienz und die Leistungseffizienz eines Bauelements auf Basis einer Struktur nach einer Ausführungsform a');
- Fig. 5 A und 5B: eine grafische Darstellung von Kenndaten für die Stromdichte und die Leuchtdichte sowie die Stromeffizienz und die Leistungseffizienz eines Bauelements auf Basis einer Struktur nach einer Ausführungsform n);
- Fig. 6: eine grafische Darstellung von Kenndaten für die Stromdichten von Bau-elementen nach Ausführungsformen o'), p'), r');
- Fig. 7: eine grafische Darstellung von Kenndaten für die Leuchtdichten die Bau-elemente nach den Ausführungsformen o'), p'), r'); und
- Fig. 8: eine grafische Darstellung des Flächenwiderstandes über der Schichtdicke zweier Löchertransportschichten mit den verschiedenen Dotanden F4-TCNQ und 2-(6-Dicyanomethylen-1, 3, 4, 5, 7, 8-hexafluoro-6H-naphtalen-2-yliden)-malononitril, die in dieselbe Matrix mit gleicher Konzentration eingebettet sind

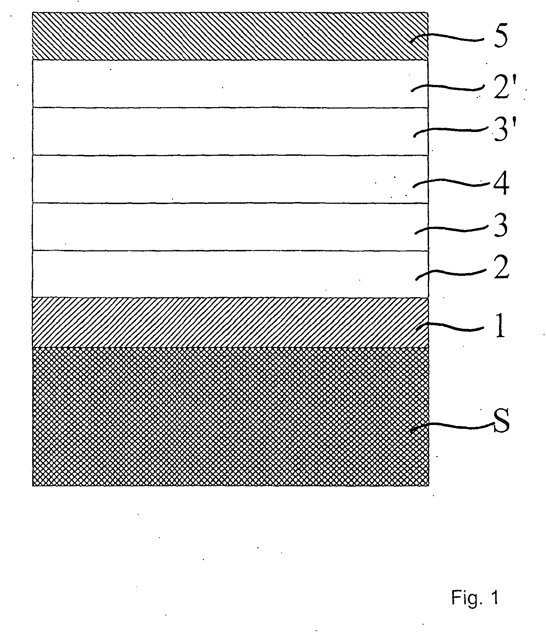

Fig. 1 zeigt einen üblichen Aufbau einer Licht emittierenden organischen Leuchtdiode (OLED). Auf einem Trägersubstrat S, zum Beispiel Glas oder poly-Si, wird eine Grundelektrode 1 strukturiert aufgebracht. Im nächsten Schritt erfolgt die schichtweise thermische Verdampfung und Abscheidung eines Stapels organischer Schichten, deren Eigenschaften weiter unten genauer spezifiziert werden. Abschließend wird eine Deckelektrode 5 aufgebracht, welche die oberste organische Schicht des vorher prozessierten Stapels bedeckt.

In jedem Fall ist mindestens eine der Elektroden transparent, um die Lichtemission zuzulassen. Im Fall einer organischen *"bottom-emission"* Diode, bei der das generierte Licht durch das Substrat abgestrahlt wird, müssen sowohl das Substrat S als auch die Grundelektrode 1 transparent sein. Hingegen ist es erforderlich, dass bei einer organischen *"top-emission"* Diode die Deckelelektrode 5 und eine Verkapselung des Bauteils ausreichend transparent sind. Es ist auch denkbar, dass beide Seiten des Bauelements transparent gestaltet sind, so dass die Diode durchsichtig erscheint.

Es soll an dieser Stelle betont werden, dass beide Elektroden 1 und 5 entweder Elektronen oder Löcher injizieren können, dass aber hier keine Einschränkung bezüglich der tatsächlichen Polarität des vorgestellten Bauelements vorgenommen werden soll. Daher kann die Erfindung sowohl in Verbindung mit invertierten (Grundelektrode als Kathode) als auch nichtinvertierten (Grundelektrode als Anode) Bauteilen sowie deren zeitsparenden und kostengünstigen Fertigungsverfahren implementiert werden.

Der nicht-invertierte Stapel organischer Schichten umfasst fünf grundlegende Komponenten: eine p-artig dotierte Löchertransportschicht 2, eine undotierte Zwischenschicht auf der Löcherseite, nämlich eine Elektronenblockschicht 3, eine Licht emittierende Emissionsschicht mit k (k=1, 2, 3, ...) Schichten, eine undotierte Zwischenschicht auf der Elektronenseite, nämlich eine Löcherblockschicht 3', und eine n-artig dotierte Elektronentransportschicht 2'.

Sollte hingegen ein invertierter Aufbau gewählt werden, so folgt auf die n-artig dotierte Elektronentransportschicht 2, eine undotierte Zwischenschicht auf der Elektronenseite, nämlich eine Löcherblockschicht 3, dann die Licht emittierende Emissionsschicht 4 mit k (k=1, 2, 3, ...) Schichten, die undotierte Zwischenschicht auf der Löcherseite, nämlich eine Elektronenblockschicht 3', und die p-artig dotierte Löchertransportschicht 2'.

Hinsichtlich der Dotanden ist anzumerken, dass Akzeptormoleküle für p-artige Dotierung vorzugsweise aus der Gruppe der Quinone ausgewählt werden (vgl: hierzu auch DE 103 57 044.6). Ein sehr bekanntes Beispiel ist F4-TCNQ, das häufig genutzt wird, um organische Löchertransportschichten zu dotieren. Dieses wurde beispielsweise von Pfeiffer ausführlich beschrieben (vgl. Appl. Phys. Lett., 73, 22 (1998)). Alternativ werden auch andere oxidierende Substanzen zur p-Dotierung eingesetzt, zum Beispiel FeCl3 (vgl. J. Endo et al.: Jpn. J. Appl. Phys. Pt. 2, 41, L358 (2002)). Zur n-Dotierung ist es üblich, Elemente aus der Gruppe der Alkalimetalle (zum Beispiel Li, Cs) oder Erdalkalimetalle (zum Beispiel Mg) zu wählen, aber auch molekulare Donatoren können verwendet werden.

Folgend wird der Stapel organischer Schichten, der nicht unter die Erfindung fällt, näher erläutert. O1 bis 04 bezeichnen hierbei allgemein unterschiedliche organische Matrixmaterialien. Die organischen Matrixmaterialien O1 bis 04 sind teilweise dotierbar, wahlweise mittels n-Dotierung und / oder p-Dotierung. Zunächst wird das gleiche organische Matrixmaterial O1 für die Schichten 2 und 3 des Stapels verwendet. Gleichzeitig wird ein anderes organisches Matrixmaterial 02 als Matrix für die beiden Schichten 2' und 3' genutzt:
p-dotiertes O1 / O1 / 4 / O2 / n-dotiertes 02

Diese Schichtanordnung entspricht einem Stapel von organischen Schichten mit einer p-dotierten Löchertransportschicht aus dem organischen Matrixmaterial O1, einer Elektronenblockschicht aus dem organischen Matrixmaterial O1, der Emissionsschicht 4, einer Löcherblockschicht aus dem organischen Matrixmaterial 02 und einer n-dotierten Elektronentransportschicht aus dem organischen Matrixmaterial 02. Diesen Ausführungsbeispielen ist gemeinsam, dass für die p-dotierte Löchertransportschicht und die angrenzende Elektronenblockschicht das gleiche organische Matrixmaterial O1 und für die n-dotierte Elektronentransportschicht und die angrenzende Löcherblockschicht das gleiche organische Matrixmaterial 02 verwendet werden. Da die p-dotierte Löchertransportschicht und die hierzu benachbarte Elektronenblockschicht wie auch die n-dotierte Elektronentransportschicht und die hierzu benachbarte Löcherblockschicht jeweils aus dem gleichen organischen Matrixmaterial sind, wobei die Transportschichten eine Dotierung aufweisen und die Blockschichten nicht, ist innerhalb der beiden Matrizen aus Transportschicht und Blockschicht jeweils ein Dotierungsgradient gebildet.

Folgende pin-Strukturen fallen nicht unter die Erfindung, bei der die Gesamtanzahl der im Stapel der organischen Schichten verwendeten organischen Matrixmaterialien die Anzahl der für die Emissionsschicht verwendeten organischen Matrixmaterialien um nicht mehr als zwei übertrifft. Das oder die für die Emissionsschicht 4 verwendeten organischen Matrixmaterialien können sowohl fluoreszent als auch phosphoreszent sein. Die Emissionsschicht kann dann als einfache Emissionsschicht (k=1) ausgelegt sein, wobei die Emissionsschicht aus:
a) O1 oder
b) O2 oder
c) O3 oder
   a') einem System aus Matrix O1:Emitter oder
   b') einem System aus Matrix 02:Emitter oder
   c') einem System aus Matrix 03:Emitter besteht.

Die Bezeichnung "MatrixOx:Emitter" bedeutet, dass die Emissionsschicht aus dem organischen Matrixmaterial Ox (x=1, 2, ...) und einem zugesetzten Emittermaterial gebildet ist. Die Emissionsschicht 4 kann aber auch als Doppelemissionsschicht (k=2) gestaltet sein, wobei
d) O1 auf der Löcherseite und 03 auf der Elektronenseite oder
e) 03 auf der Löcherseite und 02 auf der Elektronenseite oder
f) O1 auf der Löcherseite und 02 auf der Elektronenseite oder
g) 03 auf der Löcherseite und 04 auf der Elektronenseite angeordnet sind.

Die Emissionsschicht 4 kann ferner als Doppelemissionsschicht gestaltet sein, wobei als organisches Matrixmaterial für einen oder mehrere zugesetzte Emitter
d') O1 auf der Löcherseite und 03 auf der Elektronenseite oder
e') 03 auf der Löcherseite und 02 auf der Elektronenseite oder
f' ) O1 auf der Löcherseite und 02 auf der Elektronenseite oder
g') 03 auf der Löcherseite und 04 auf der Elektronenseite
gewählt werden.

Die organischen Matrixmaterialien der Transportschichten des Schichtstapels der nicht erfindungsgemäßen pin-Struktur sind also jeweils identisch mit den angrenzenden Blockschichten oder sogar einer Komponente der Emissionsschicht. Voraussetzung dafür ist allerdings, dass sich das organischen Matrixmaterial O1 (bzw. 02) mit Akzeptoren (Donatoren) dotieren lässt und gleichzeitig als Barriere für Elektronen (Löcher) im organischen Stapel fungiert, währenddessen sie außerdem zulässt, dass Löcher (Elektronen) in die Emissionszone gelangen. Ausnahme sind die obigen Beispiele c), c'), g) und g'), bei denen sich das organische Matrixmaterial der Emissionsschicht von dem der Blockschichten unterscheidet.

Die angegebenen Strukturen sind das Ergebnis umfangreicher Untersuchungen und im Vergleich zu bekannten komplexen Strukturen, wie sie beispielsweise in dem Dokument DE 100 58 578 C2 angegeben sind, wesentlich vereinfacht. Es wurden darüber hinaus kritische Parameter bestimmt, die die jeweiligen Materialien für eine bestimmte Funktion, nämlich insbesondere als dotierte Ladungsträgertransportschicht, Blockschicht oder Emissionsschicht, bevorzugt aufweisen. Diese Parameter sind vor allem die energetischen Positionen der geladenen bzw. angeregten Zustände dieser Moleküle. Die Beschreibung dieser Parameter erfolgt unten.

Kombiniert wurden diese Untersuchungen mit umfangreichen Testreihen zur Identifizierung von Materialien, deren Eigenschaften ihren Einsatz für eine Mehrzahl der benötigten Funktionen ermöglichen. Zum tieferen Verständnis wurden Simulationen von OLEDs mit einem speziell entwickelten Programm durchgeführt. Die Vorgehensweise wird im folgenden beispielhaft beschrieben, und die gewonnenen Erkenntnisse und daraus abgeleitete Designregeln werden angeben.

Die Vorgehensweise wird am folgenden nicht erfindungsgemäßen Beispiel der Löchertransportschichten benachbart zur Anode erläutert. Es wird eine pin-OLED mit MeO-TPD als Löchertransportschicht, Spiro-TAD als Elektronenblockschicht und TAZ als anodenseitige Emittermatrix eingesetzt, wie dies bekannt ist (vgl. He et al.: Appl. Phys. Lett., 85 (17), 3911 (2004)). Eine Betrachtung der Ionisationspotentiale der beteiligten Stoffe ergibt, dass die Barriere für Löcher beim Transport von Löchertransportschicht zur Elektronenblockschicht 0.3eV beträgt. Die Löcherinjektion aus der Elektronenblockschicht in die Emissionsschicht erfolgt barnerefrei (vgl. Pfeiffer et al.: Adv. Mat., 14 (22), 1633 (2002)). Die Barriere für die Injektion von Löchern aus der Anode in die Löchertransportschicht beträgt etwa 0.5 eV. Es ist bekannt, dass die Anode aus ITO mit Löchertransportmaterialien mit ähnlichem Ionisationspotential wie MeO-TPD ohmische Kontakte bildet. Die von He et al. angegebene anodenseitige OLED-Struktur entspricht bzgl. der Potentiallagen der beteiligten Stoffe im Wesentlichen den Strukturen, die bisher für pin-OLEDs mit Blockschichten berichtet wurden, zuerst von Zhou et al. (Appl. Phys. Lett. 80 (1),139 (2002)).

Um eine einfache OLED-Struktur zu realisieren, wurde die Anzahl der verwendeten Matrixmaterialien verringert. Alle bekannten Realisierungen von effizienten pin-OLEDs verwenden unterschiedliche Matrixmaterialen für die Löchertransportschicht und die Elektronenblockschicht. Die Ursache hierfür ist, dass die Dotierbarkeit der Löchertransportschicht einerseits und die gute Funktion der Elektronenblockschicht andererseits sehr unterschiedliche Anforderungen an die Eigenschaften dieser Schichten stellen.

Es wurde zunächst die p-dotierte Löchertransportschicht aus Spiro-TAD hergestellt. Hierbei ergab sich, dass Spiro-TAD nicht ausreichend mit dem üblicherweise verwendeten Akzeptormolekül F4-TCNQ dotiert werden kann. Das führt dazu, dass der Kontakt zu ITO nicht mehr ohmisch ist und Lichtemission nur bei vergleichsweise hohen Betriebsspannungen beobachtet werden kann. Es wurde weiterhin die Elektronenblockschicht aus undotiertem Spiro-TTB (2,2',7,7'-Tetrakis-(N,N-ditolylamino)-9,9'-spirobifluoren) hergestellt, während die Löchertransportschicht aus p-dotiertem Spiro-TTB besteht. In Hinblick auf das Ionisationspotential und die Dotierbarkeit mit F4-TCNQ ist dieses Material als äquivalent mit MeO-TPD zu betrachten. Hierbei ergab sich, dass zwar ein ohmscher Kontakt zu ITO gebildet wird, andererseits aufgrund der hohen Barriere für Löcherinjektion in die hier verwendete Emissionsschicht geringe Effizienzen für Lichtemission auftreten. Die Ursache sind Quenching-Effekte aufgrund von Exziplexbildung und Lumineszenzlöschung an den angestauten Löchern an der Grenzfläche zwischen Blockschicht und Emissionsschicht. Weiterhin wurden andere Löcher transportierende Materialien mit höherem Ionisationspotential als MeO-TPD, aber geringerem Ionisationspotential als Spiro-TAD als p-dotierte Löchertransportschicht und als Elektronenblockschicht verwendet. Hierbei wurde festgestellt, dass keines der Materialien einerseits im dotierten Fall ohmsche Kontakte mit ITO bildet und gleichzeitig andererseits auch keine Quenching-Effekte in der Emissionsschicht hervorruft. Elektrische Simulationen ergaben, dass eine Barriere von etwa 200meV zwischen zwei organischen Schichten den Stromtransport noch nicht wesentlich beeinflusst, bei etwa 400meV aber schon erhebliche Staubildung auftritt.

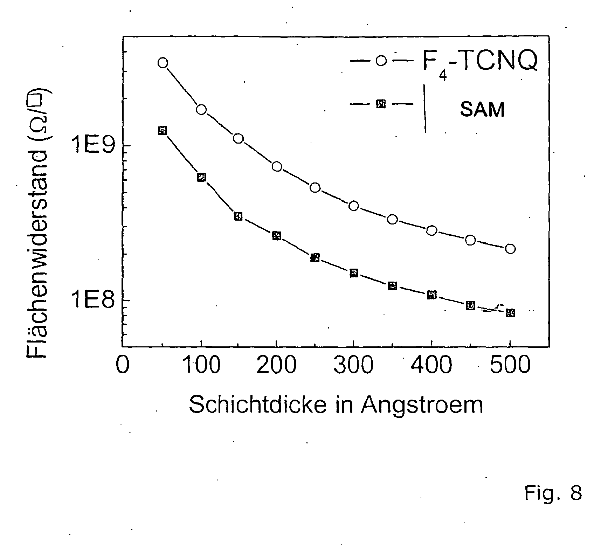

Es wurde erkannt, dass sich eine Lösung des Problems ergeben kann, wenn stärkere Akzeptormoleküle als F4-TCNQ verwendet werden. Dann ließen sich auch Materialien mit höherem Ionisationspotential als MeO-TPD oder Spiro-TTB dotieren, unter Umständen sogar Spiro-TAD. Allerdings waren stärkere Akzeptormoleküle als F4-TCNQ im Stand der Technik bisher nicht bekannt. Es wurde ein stärkeres Akzeptormolekül als F4-TCNQ verwendet, bei dem es sich um 2-(6-Dicyanomethylen-1, 3, 4, 5, 7, 8-hexafluoro-6H-naphtalen-2-yliden)-malononitril handelt und welches im folgenden als SAM bezeichnet wird (vgl. Fig. 8). Es stellte sich heraus, dass so tatsächlich eine Dotierung von Spiro-TAD gelingt. Es war so möglich, die dotierte Löchertransportschicht und die Elektronenblockschicht aus demselben Material (Spiro-TAD) auszubilden und gleichzeitig eine gute Injektion aus der mit ITO ausgebildeten Anode und geringe Quenching-Effekte an der Grenzfläche zur Emissionsschicht zu gewährleisten.

Schließlich wurde Spiro-TAD auch als Matrixmaterial für rote Triplett-Emitter eingesetzt, was eine noch weitere Vereinfachung der OLED ermöglichte (vgl. Anwendungsbeispiel a') oben).

In einem nächsten Schritt wurde untersucht, inwieweit bei den neuartigen Schichtstrukturen überhaupt die Notwendigkeit für eine oder mehrere Blockschichten besteht. Blockschichten können eingesetzt werden, um negative Quenching-Effekte zu vermeiden. Bisher weisen alle effizienten OLEDs mit pin-Struktur zwei Blockschichten auf, jeweils eine kathodenseitig und eine anodenseitig.

Wichtig für das Verständnis der Quenching-Effekte ist die Kenntnis über die Lage der Rekombinationszone der pin-OLEDs. Da Exzitonen in organischen Schichten in der Regel eine begrenzte Diffusionslänge in der Größenordnung von 10nm aufweisen, existiert im Bauelement auch nur innerhalb des Diffusionsbereichs eine nennenswerte Exzitonendichte. Da Quenchingeffekte in der Regel auf kurzreichweitige Wechselwirkungen mit Exzitonen zurückgehen, muß die Quelle dieser Effekte innerhalb der Diffusionszone um den Rekombinationsbereich herum gelegen sein, um die Effizienz spürbar zu verschlechtern. Über die Lage der Emissionszone in pin-OLEDs ist wenig bekannt. Für herkömmliche OLEDs wurden Experimente mit der so genannten *"doped slab"-*Technik durchgeführt. Dabei wurden verschiedene OLEDs gleicher Struktur hergestellt, für die jeweils eine sehr dünne Exzitonensensorschicht an verschiedene Positionen in der Emissionsschicht eingeführt wurde. Das Lumineszenzsignal der Exzitonensensorschicht wird als proportional zu Exzitonendichte am Ort angenommen. In herkömmlichen OLEDs wurde zwischen sog. elektronenreichen bzw. elektronenarmen Strukturen unterschieden. In ersteren befindet sich die Rekombinationszone vorrangig auf der anodischen Seite der Emissionsschicht, während sie sich im zweiten Fall auf der kathodischen Seite befindet. Ursache für Elektronenüberschuß bzw. Elektronenmangel sind dabei neben der verschieden großen Beweglichkeit für Elektronen und Löcher vor allem die Barrieren für die Ladungsträgerinj ektion.

Für die Untersuchung von pin-Dioden wurde ferner eine andere Methode gewählt, nämlich der Vergleich von OLEDs mit einer Variation der Dicken der Transportschichten mit einem optischen Modell. Diese Variation führt zu einer Variation der Entfernung der Emissionsschicht von der reflektierenden Elektrode, bei der es sich häufig um die Kathode handelt. Aufgrund von Interferenz in dem entstehenden Dünnschichtsystem ergeben sich Verschiebungen im Emissionsspektrum und eine Variation der Auskopplungseffizienz und der Emissionscharakteristik.

Der Vergleich von Experiment und optischer Simulation für verschiedene Lagen der Emissionszone im Stapel ermöglicht die Bestimmung von deren tatsächlicher Lage im Bauelement. Im Ergebnis dieser Experimente wurde gefunden, dass für pin-OLEDs die Lage der Emissionszone nicht durch Barrieren für Ladungsträgerinjektion gegeben ist, sondern vorrangig aufgrund des Verhältnisses der Beweglichkeiten für Elektronen und Löcher in der Emissionsschicht. Die Unterscheidung zwischen elektronenarmen und elektronenreichen OLEDs verliert so ihre ursprüngliche Bedeutung. Überwiegt die Elektronenbeweglichkeit gegenüber der Löcherbeweglichkeit in einer konkreten emittierenden Schicht, findet die Rekombination in der Nähe der Elektronenblockschicht statt. Dieses bedeutet, dass in diesem Fall bei genügender Dicke der Emissionsschicht die Exzitonendichte an der Löcherblockschicht sehr gering ist. Quenching-Effekte spielen an dieser Grenzfläche also keine Rolle, und auf die Löcherblockschicht kann verzichtet werden. Analog kann bei überwiegender Löcherbeweglichkeit auf die Elektronblockschicht verzichtet werden. Zur Überprüfung wurden OLEDs hergestellt (siehe unten), bei denen keine undotierte Zwischenschicht zwischen die Löchertransportschicht und die Emissionsschicht mit einer dominierenden Löcherbeweglichkeit eingefügt ist. Herkömmlich werden für solche OLEDs starke Quenchingeffekte erwartet, da die Anforderungen für praktisch alle Arten von Lumineszenzlöschung an der Grenzfläche gegeben sind, nämlich die Anwesenheit der geladenen Dotandenanionen, die Ansammlung einer hohen Löcherdichte aufgrund einer hohen Barriere zur Emissionsschicht und die energetische Zulässigkeit von Exziplexbildung. Tatsächlich wurde jedoch beobachtet, dass die Effizienzen dieser Strukturen sehr hoch ist. Ein überraschendes Ergebnis, das aber mit Hilfe der obigen Begründung erklärt werden kann.

Im folgenden werden Eigenschaften hinsichtlich der Energielagen der beteiligten Materialien für die Herstellung von effizienten, aber einfach aufgebauten OLEDs zusammengefasst.

Da die verfügbaren Akzeptoren (Donatoren) eine begrenzte Dotierstärke (nach Maßgabe der Elektronenaffinitäten bzw. Ionisationspotentiale) besitzen, ergeben sich daraus für die organischen Matrixmaterialien O1 bis 04 Maximalwerte für das Ionisationspotential (Minimalwerte für die Elektronenaffinität). Um zusätzlich als Elektronen- (Löcher-) Barriere zu dienen, ergeben sich zusätzlich Maximalwerte für die Elektronenaffinität (Minimalwerte für das Ionisationspotential) der organischen Matrixmaterialien.

Das kommerziell erhältliche Akzeptormolekül F4-TCNQ kann als p-Dotand in einem Löchertransportmaterial eingesetzt werden. Es hat eine Elektronenaffinität EA(A) von etwa 5.3 eV (Abschätzung aus Cyclovoltammetrie). Für eine mit F4-TCNQ dotierte Matrix O1 ergibt sich so die Anforderung, dass das Ionisationspotential IP(O1) (abgeschätzt aus Cyclovoltammetrie) höchstens 0.5 eV größer ist. Als Donator werden häufig Cäsiumatome eingesetzt. Atomares Cäsium besitzt ein Ionisationspotential von 3.9 eV. Aufgrund einer starken Wechselwirkung zwischen Matrix und Dotand (Komplexbildung) ist es jedoch möglich, Matrixmaterialien mit weit geringerer Elektronenaffinität zu dotieren. Das gut bekannte Matrixmaterial BPhen hat beispielsweise eine Elektronenaffinität zwischen 3.0 eV (Abschätzung aus Ionisationspotential und optischer Bandlücke) und 2.4 eV (Abschätzung aus Cyclovoltammetrie). Es kann aber erwartet werden, dass für Materialien mit einer um 0.5 eV geringeren Elektronenaffinität eine Dotierwirkung mit Cäsium nicht erreicht werden kann. Für einen molekularen n-Dotanden ergibt sich in Anlehnung an die Ausführung für p-Dotanden, dass die Elektronenaffinität der Matrix EA(02) den um 0.5 eV erniedrigten Wert des Ionisationspotentials des Donators IP(D) nicht unterschreiten darf.

### Aus dem Erfordernis der Dotierbarkeit ergeben sich mithin die Beziehungen:

IP(O1)<EA(A)+0.5 eV bzw. EA(02)>IP(D)-0.5 eV. Im Falle einer Dotierung mit Cäsium gilt EA(02)>1.9 eV.

Zur Erfüllung der Barriereeigenschaften ergeben sich die Anforderung an EA(O1) bzw. IP(02) aus den Potentiallagen der Emissionsschicht. Elektronen, die sich energetisch in Höhe der Elektronenaffinität der Emissionsschicht EA(E) bewegen, dürfen nur mit einer geringen Rate in die Schicht O1 gelangen. Damit ergibt sich: EA(O1)<EA(E)-0.2eV. Gleichzeitig dürfen Löcher, die sich energetisch in Höhe des Ionisationspotentials der Emissionsschicht IP(E) bewegen, nur mit einer geringen Rate in die Schicht 02 gelangen: IP(O2)>IP(E)+0.2eV. Es sei hier noch einmal daran erinnert, dass die Bedingungen für Barriereeigenschaften nicht in jedem OLED-Stapel erfüllt sein müssen: Ist die Emissionszone nahe der Lochtransportschicht gelegen, besteht häufig keine Notwendigkeit, dass die an den Emissionsstapel kathodenseitig angrenzende Schicht eine Barriere für Löcher darstellt. Ebenso gilt für eine OLED mit einer Emissionszone nahe der Elektrontransportschicht, dass häufig keine Notwendigkeit besteht, dass die an den Emissionsstapel anodenseitig angrenzende Schicht eine Barriere für Elektronen darstellt.

Zum Erreichen einer effizienten Injektion von Ladungsträgern aus den jeweiligen Ladungsträgertransportschichten bzw. den Blockschichten in die Emissionsschicht ist zu fordern, dass die hierbei von den Ladungsträgern zu überwindende Barrieren nicht zu groß, d.h. kleiner als 0.5 eV sind. Hierbei ist zu betonen, dass bei höheren Barrieren zum einen mit einer Erhöhung der Betriebsspannung zu rechnen ist. Zum anderen kann aber auch eine Verringerung der Effizienz der Emission auftreten, wenn die angestaute Ladungsträgerdichte an der Grenzfläche zur Emissionsschicht zu einer Zunahme der nicht-strahlenden Rekombinationen von Exzitonen in der Emissionsschicht führt. Insgesamt ergeben sich diese Kriterien: IP(O1)>IP(E)-0.5 eV und EA(02)<EA(E)+0.5 eV.

Es ist zunächst überraschend, dass zwar einerseits eine effiziente Ladungsträgerinjektion in die Emissionsschicht erfolgen kann, wenn die Barriere bis zu 0.5 eV beträgt, andererseits jedoch die Leistung der Leuchtdiode nicht beeinträchtigt wird, wenn die Barriere für die Injektion aus der Emissionsschicht in die Blockschicht nur 0.2 eV beträgt. Dies ist darauf zurückzuführen, dass innerhalb der Emissionsschicht die erwünschte Rekombination von Elektronen und Löchern als konkurrierender Prozess zum Ladungsträgerverlust in die Blockschichten auftritt. Deshalb ist die Verweilzeit von Ladungsträgern in der Nähe der Barriere in der Emissionsschicht deutlich kürzer als im Falle einer unipolaren Ladungstransportschicht. Dies führt zu einer Begrenzung der Ladungsträgerverluste auch für vergleichsweise geringe Barrieren. Materialbeispiele sind: BPhen kann mit Cäsium dotiert werden, gleichzeitig aber auch als Löcherblockschicht und Matrix für das grün emittierende Molekül Ir(ppy)3 genutzt werden.

Auf der Löcherseite bietet Spiro-TAD die Möglichkeit gleichzeitig zur p-Dotierung und als Elektronenblockschicht und funktioniert zudem auch als Matrix zum Beispiel für rote Emitter.

Im folgenden werden weitere nicht erfindungsgemäße Beispiele für Schichtanordnungen in dem Stapel organischer Schichten für eine organische Leuchtdiode vom pin-Typ näher erläutert. O1 bis 04 bezeichnen wieder allgemein unterschiedliche organische Matrixmaterialien.
m) p-dotiertes O1 / O1 / O1:Emitter / 03 / n-dotiertes 02
n) p-dotiertes O1 / O3 / O2:Emitter / 02 / n-dotiertes 02

Eine solche Anordnung führt, wie zuvor beispielhaft erläutert, zur Ausbildung einer Art Einheitsübergang auf jeweils nur einer Seite der Emissionsschicht, die in den Ausführungsformen unten als unterstrichener Text dargestellt ist. Ein Einheitsübergang im Sinne der Erfindung ist eine Schichtfolge, die von einer Ladungsträgertransportschicht bis zur Emissionsschicht mittels einer einheitlichen Matrix gebildet ist. Befindet sich die Emissionszone inmitten der Emissionsschicht, können die Blockschichten weggelassen werden. Dies führt zu den nicht erfindungsgemäßen Strukturen m*) und n*):
m*) p-dotiertes O1 / / O1:Emitter / n-dotiertes 02
n*) p-dotiertes O1 / 02:Emitter / n-dotiertes 02

Nach der schrittweisen Anpassung der Schichtmaterialien (vgl. Ausführungsbeispiele o), o*), p), p*), q) unten) können die Strukturen der Ausführungsbeispiele r), s), t) realisiert werden, wobei sich die HOMO und LUMO-Niveaus an den Grenzflächen perfekt angleichen, da dort durchgehend in allen Schichten dasselbe Matrixmaterial genutzt wird:
o) p-dotiertes O1 / O1 / O1:Emitter / 02 / n-dotiertes O1
o*) p-dotiertes O1 / O1:Emitter / 02 / n-dotiertes O1
p) p-dotiertes O1 / O2 / O1:Emitter / n-dotiertes O1
p*) p-dotiertes O1 / O2 / O1:Emitter / O1 / n-dotiertes O1
q) p-dotiertes O1 / O2 / O1:Emitter / 03 / n-dotiertes O1
r) p-dotiertes O1 / O1 / O1:Emitter / n-dotiertes O1
s) p-dotiertes O1 / O1:Emitter / O1 / n-dotiertes O1
t) p-dotiertes O1 / O1:Emitter / n-dotiertes O1

Dabei sind Strukturen o), p*), r) und s) Ausführungsbeispiele der Erfindung.

Weiterhin kann die Emissionsschicht in den Strukturen der Ausführungsbeispiele m) bis t) sogar nur aus einem der Materialien O1, O2 oder 03 bestehen:
m') p-dotiertes O1 / O1 / 03 / n-dotiertes 02
m") p-dotiertes O1 / O1 / n-dotiertes 02
n') p-dotiertes O1 / O3 / O2 / n-dotiertes 02
n") p-dotiertes O1 / 02 / n-dotiertes 02
o') p-dotiertes O1 / O1 / O2 / n-dotiertes O1
p') p-dotiertes O1 / O2 O1 / n-dotiertes O1
q') p-dotiertes O1 / O2 O1 / O3 / n-dotiertes O1
r' = s' = t') p-dotiertes O1 / O1 / n-dotiertes O1

Alle Schichtkombinationen, die oben aufgelistet sind, können in invertierten und in nichtinvertierten OLEDs eingesetzt werden, je nach Polarität der Grund- und Deckelelektrode. Die Strukturen in den Ausführungsbeispielen m) bis t') umfassen alle nur eine Emissionsschicht aus einem einzelnen Matrixmaterial, also gilt k = 1. Analog gelten die genannten Vereinfachungen jedoch auch für die Strukturen in den Ausführungsbeispielen m) bis q) und m') bis q') für k= 1, 2, 3, ... Insbesondere bei weißen OLEDs ist k häufig größer als 1, da sich das weiße Spektrum aus Beiträgen verschiedener Farben zusammensetzt.

Die größte Herausforderung beim Bau einer OLED mit der selben Matrix für p- und n-Dotierung ist das Finden eines Matrixmaterials, das sich sowohl mit einem p- als auch mit einem n-Dotanden dotieren lässt, so dass es in der Löcher- und der Elektronentransportschicht eingesetzt werden kann. Für den Fall, dass dieses Material auch als Emitter oder Emitter-Host eingesetzt werden soll, muss seine Energielücke zwischen HOMO und LUMO in einem Bereich liegen, der es Elektronen und Löchern erlaubt, in die Emissionszone einzudringen und dort strahlend zu rekombinieren. Die erläuterten Angaben für die Orbitallagen der Matrix ergeben sich direkt aus den oben angestellten Erwägungen unter der Maßgabe der Identität der organischen Matrixmaterialien O1 und 02. Phthalocyanine, zum Beispiel ZnPc und CuPc, Phorphyrine, zum Beispiel ZnOEP, PtOEP oder Iridium (III) Tris (1-phenylisoquinolin) sind Materialien, die verwendet wurden.

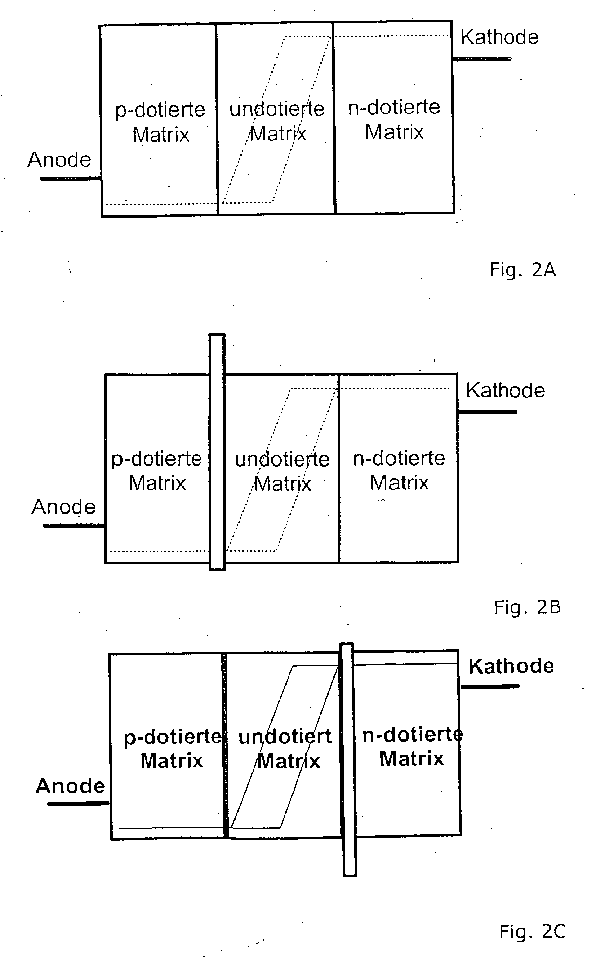

Im folgenden wird auf die Fig. 2A bis 2C Bezug genommen. Eine einfache Struktur kann durch ein Dreischichtsystem realisiert werden welches zum Beispiel oben als Ausführungsform r') gezeigt ist. Im Prinzip passen HOMO und LUMO-Niveaus an jeder Grenzfläche perfekt zusammen, wenn es sich auf beiden Seiten der Grenzfläche um das gleiche Matrixmaterial handelt. Das heißt, es gibt in einer solchen OLED innerhalb der Organik überhaupt keine Energiebarriere, weder für die Elektronen auf ihrem Weg durch das LUMO noch für die Löcher auf ihrem Weg durch das HOMO.

Um niedrige Betriebsspannungen der OLED zu erreichen, werden beide Ladungsträgertransportschichten dotiert. Das setzt voraus, dass das Matrixmaterial sowohl p- als auch n-dotierbar ist. Die Balance der beiden Ladungsträgerarten, die für eine hohe Stromeffizienz ausgeglichen sein muss, lässt sich über den Grad der p- und n-Dotierung einstellen.

Der größte Vorteil dieser Struktur ist ihre einfache Prozessierung. Hierbei ist jedoch Ladungsträgerbalance einzustellen. Diese kann nämlich auch von der angelegten Spannung, und somit von der Helligkeit abhängen. Ein weiterer Parameter, der berücksichtigt werden muss, ist die Exzitonendiffusionslänge. Ist sie so groß, dass die Exzitonen aus der Emissionszone herausdiffundieren können, wird auch das die Effizienz verringern.

Zusätzlich muss eine (vgl. Fig. 2B und 2C; Ausführungsbeispiele o*), o'), p), p')) oder gegebenenfalls sogar zwei (vgl. Ausführungsbeispiele o), q), p*) und q')) Blockschichten eingeführt werden, die Löcher und Elektronen in der Emissionsschicht eingrenzen. In diesem Fall wirkt die Energiedifferenz der LUMOs / HOMOs der Schicht 3 / 3' und der Emissionsschicht 4 (vgl. Fig. 1) als Barriere für die Elektronen / Löcher bei einem nicht-invertiertem Aufbau. Dies gilt analog für einen invertierten Aufbau. Dadurch werden die Ladungsträger in der Emissionsschicht akkumuliert, was wiederum effiziente Lichtgeneration zur Folge hat.

Gelegentlich finden sich in OLED-Strukturen weitere Schichten, die zwischen die Kontakte und die hier beschriebenen Schichtstrukturen eingebracht werden. Diese Schichten können beispielsweise die Verbesserung der Ladungsträgerinjektion oder einer besseren Adhäsion des Kontaktes an den organischen Schichten dienen. Es versteht sich, dass die beschriebenen Schichtstrukturen auch solche OLEDs betreffen, die diese Art von Schichten zusätzlich zum hier beschriebenen Schichtstapel beinhalten. Dieses bezieht sich nicht nur auf farbige, sondern auch auf weiße OLEDs.

Besonders attraktiv ist die erfindungsgemäße Vereinfachung des Schichtstapels für die Anwendung in sogenannten *"stacked"* OLEDs. Unter *"pin-stacked"* OLEDs versteht man üblicherweise OLEDs mit mehreren pin-Schichtfolgen übereinander. Diese OLEDs erlauben hohe Stromeffizienzen und das Mischen von Farben bei Verwendung unterschiedlich emittierender Emissionsstapel in den einzelnen Sub-pin-OLEDs. Gerade bei diesen OLEDs, die aus zehn oder mehr Schichten bestehen können, ist die Einsparung jeder einzelnen Schicht ein Garant für höhere Produktionsausbeute und kostengünstigere Herstellung.

Eine wichtige Anwendung für OLEDs sind vollfarbige Displays mit roten, grünen und blauen Subpixeln. Auch für diese Anwendung werden pin-Strukturen genutzt, wobei man versucht, lediglich den Emissionsschichtstapel bzw. die Emissionsschicht durch eine Schattenmaske strukturiert aufzubringen, um die drei unterschiedlich farbigen Subpixelarten zu erreichen. Alle anderen Schichten, also zum Beispiel die Transport- und Blockschichten sollen für die drei Farben gemeinsam aufgebracht werden. Das bedeutet aber man kann zum Beispiel eine Blockschicht auf der Elektronenseite nur dann weglassen, wenn die so vereinfachte OLED für alle drei Farben gleichermaßen gut funktioniert. Durch das gewonnene Wissen lassen sich jetzt die Emittermatrizen gezielt so auswählen, dass für alle drei Farben auf den gleichen Blocker verzichtet werden kann. Zum Beispiel könnte man für alle drei Farben Emittermatrizen wählen, die vorwiegend Löcher transportieren und daher ggf. auf den Elektronenblockschicht verzichten.

Nachfolgend werden in Ergänzung zu den bereits beschriebenen Ausführungen weitere Beispiele für die Realisierung der vereinfachten Schichtstrukturen beschrieben. Hierbei wurde SAM als p-Dotand verwendet.

### i) Beispiel für eine nicht erfindungsgemäße Struktur nach der Ausführungsform c')

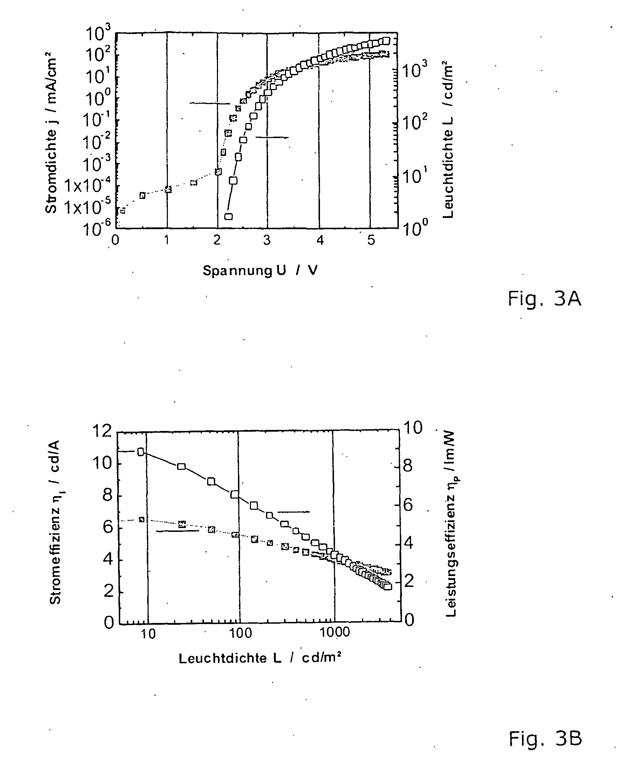

Eine rote bottom-emittierende OLED wurde auf ITO mit Spiro-TTB als organischem Matrixmaterial für die Lochtransportschicht und als Elektronblockschicht prozessiert. Auf der Elektronenseite wurde eine Kombination von undotiertem und Cs-dotiertem BPhen implementiert. Als Deckelektrode wurde eine reflektive Aluminiumkathode aufgebracht. Die Emissionsschicht besteht aus dem Emittersystem NPD:Iridium(III) bis (2-methyldibenzo[f,h]-quinoxalin)(acetylacetonat). Kenndaten sind in den Fig. 3A und 3B dargestellt. Bei nur 2.6 V wird Licht mit einer Helligkeit von 100 cd/m² und einer Effizienz von 6,6 1m/W emittiert.

### ii) Beispiel für eine nicht erfindungsgemäße Struktur nach der Ausführungsform a')

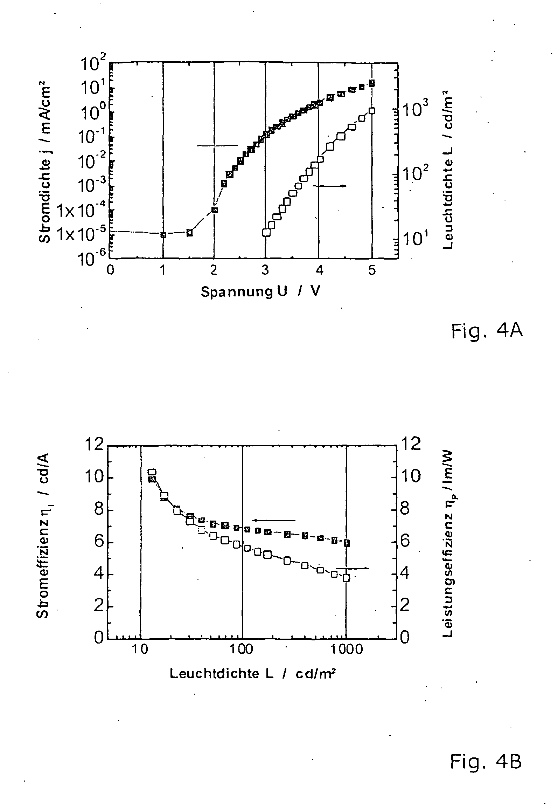

Im Gegensatz zum vorigen Beispiel, wird hier Spiro-TAD als Matrix für die Lochtransportschicht, als Zwischenschicht 3 und als Matrix für den Emitterfarbstoff Iridium (III) Tris (1-phenylisoquinolin) eingesetzt. Alle anderen Schichten wurden analog zum vorigen Beispiel aufgewachsen. Kenndaten sind in den Fig. 4A und 4B dargestellt. Die Leistungseffizienz erreicht 5,7 lm/W bei einer Helligkeit von 100 cd/m² und einer Betriebsspannung von 3.7 V.

### iii) Beispiel für eine nicht erfindungsgemäße Struktur nach der Ausführungsform n)

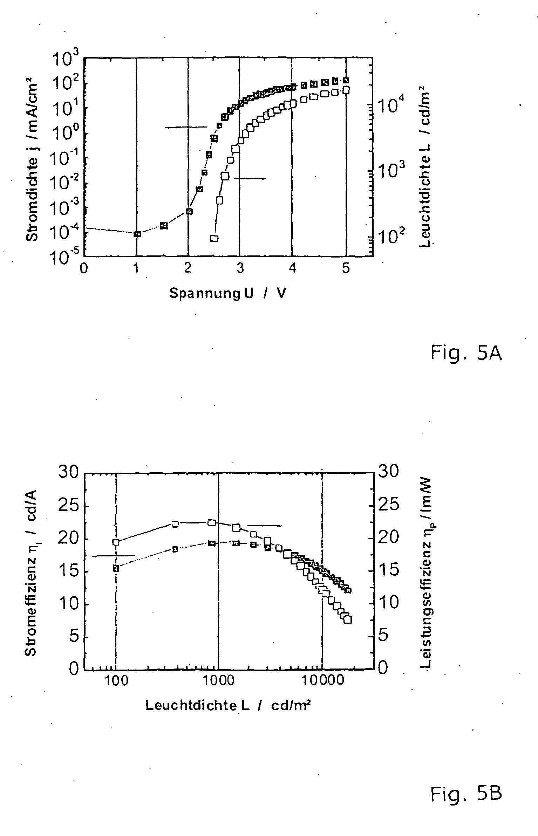

Es wird ein Einheitsübergang auf der Elektronenseite mit Hilfe einer Bphen-Matrix realisiert, die mit Cs dotiert wird, um eine hohe n-Leitfähigkeit zu gewährleisten. BPhen wird ferner als Lochblockschicht und als Matrixmaterial für den grün emittierenden Emitter Ir(ppy)3 genutzt. Auf der p-Seite wurde mit SAM p-dotiertes Spiro-TTB auf transparentes ITO aufgebracht und darauf undotiertes Spiro-TAD als Elektronblockschicht, die die Elektronen in der Emissionszone eingrenzt, abgeschieden. Kenndaten sind in den Fig. 5A und 5B dargestellt. Steile Strom-Spannungskennlinien wurden gemessen. 1000 cd/m² wurden bei einer Betriebsspannung von 2,75 V und einer Leistungseffizienz von 22,2 lm/W erreicht.

### iv) Beispiel für eine jeweilige nicht erfindungsgemäße Struktur nach den Ausführungsformen o'), p'), r')

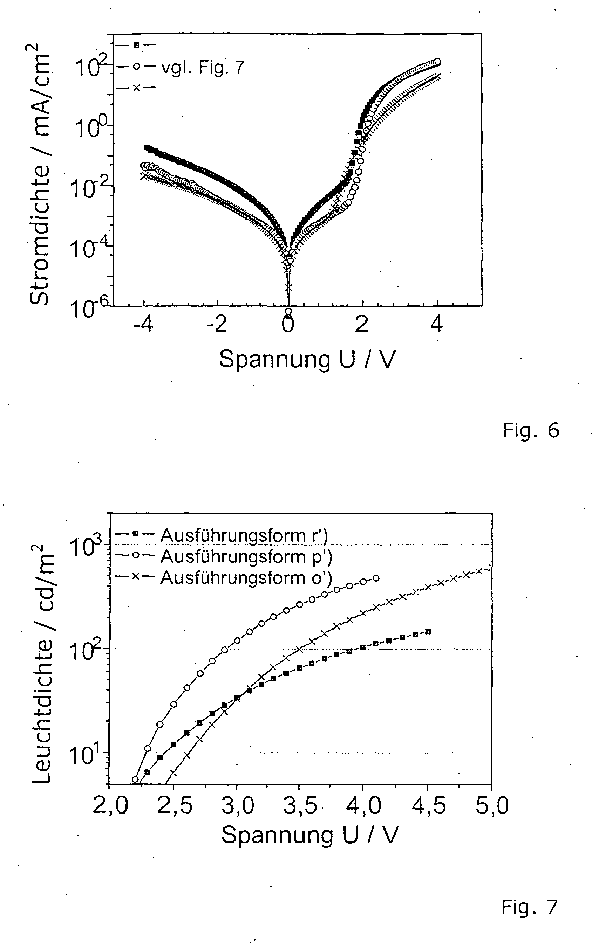

Das rot emittierende Material Iridium (III) Tris (1-phenylisoquinolin) ist ein passendes organisches Matrixmaterial, welches sowohl beim Dotieren mit Akzeptoren als auch mit Donatoren eine erhöhte Leitfähigkeit zeigt. Es wurden drei OLEDs basierend auf diesem Matrixmaterial gebaut, nämlich eine Diode ohne Blockschichten, eine Diode mit MeO-TPD, das als Elektronenblockschicht (EB) eingesetzt wurde, und eine Diode in der 4,7-diphenyl-2,9-dicyano-1,10-phenanthrolin(bathophenanthrolin) als Lochblockschicht eingesetzt wurde. Als n-Dotand wurde Cs verwendet. Kenndaten dieser Dioden sind in den Fig. 6 und 7 gezeigt. Alle Proben zeigen eine gute Diodencharakteristik. Die Diode mit EB emittierte rotes Licht einer Helligkeit von 100 cd/m² bei 2.9 V. Deutlich erkennt man, dass durch Einsatz der Blockschichten die Leuchtdichte der Dioden erhöht wird.

Insgesamt werden mit den beschriebenen Anordnungen organischer Schichten neue Gestaltungsmöglichkeiten betreffend das Zusammenspiel zwischen Blockschicht und Ladungsträgertransportschicht und Emissionsschicht geschaffen. Ausgehend von vereinfachten OLED-Struktur wurde weiterhin ein Verfahren geschaffen, wie OLEDs deutlich einfacher prozessiert werden können. Ausgangspunkt ist die Verwendung desselben organischen Matrixmaterials für mehrere Schichten, zum Beispiel als Matrixmaterial für den p-Dotand, als ElektronenBlocker und als Matrixmaterial für die Emissionsschicht. Es werden bei der Herstellung solcher Schichtanordnungen eine oder mehrere Verdampfungsquellen für weitere Matrixmaterialien eingespart, die bei bekannten Verfahren aufzudampfen sind. Darüber hinaus ist es ermöglicht, die Quelle für das Matrixmaterial kontinuierlich zu betreiben: Zunächst findet eine Co-Verdampfung der Matrix mit dem p-Dotanden statt (Aufdampfen der Löchertransportschicht). Dann wird der Verschluss der Quelle des p-Dotanden geschlossen und nur die Matrix weiter verdampft (Aufdampfen der Elektronenblockschicht). Dann wird der Verschluss für den Emitterfarbstoff geöffnet, und der Emitterfarbstoff wird zusammen mit dem Matrixmaterial co-verdampft (Aufdampfen der Emissionsschicht). Diese Vorgehensweise spart Zeit für das Hoch- und Runterheizen der Quelle für das Matrixmaterial und Kosten, da nur eine Quelle für das Matrixmaterial genutzt wird.

Die Vielzahl von Kriterien, die bei der Auswahl und der Kombination von organischen Matrixmaterialien für den Ladungsträgertransport, die Ladungsträgerblockade und die Lichtemission in organischen Leuchtdioden vom pin-Typ beachtet werden müssen, führen nicht notwendigerweise dazu, dass diese Matrixmaterialien paarweise verschieden sein müssen. Beispielsweise kann ein- und dasselbe organische Matrixmaterial, zum Beispiel Spiro-TAD, neben seiner bekannten Verwendung als Blockmaterial auch als Matrixmaterial für eine Löchertransportschicht verwendet werden, obwohl das Kriterium der Dotierbarkeit und das Kriterium der geringen Barriere für die Injektion von Löchern in die Emissionsschicht zueinander im Gegensatz stehen. Hierbei werden neuartige Akzeptoren, beispielsweise SAM, einbezogen, die die Klasse der p-dotierbaren Matrizen beträchtlich erweitern. Insbesondere können jetzt auch Materialien, die früher ausschließlich als Blockmaterial eingesetzt werden, nun auch als p-dotiertes Löchertransportmaterial eingesetzt werden.

Weiterhin wurde erkannt, dass in nicht erfindungsgemäßen Ausführungsformen der Einsatz einer Blockschicht für eine Ladungsträgersorte verzichtbar sein kann, insbesondere wenn die Beweglichkeit dieser Ladungsträgersorte die Beweglichkeit der anderen Ladungsträgersorte derart übertrifft, dass die Emissionszone sich weit auf der entgegengesetzten Seite der Emissionsschicht befindet. In diesem Falle ist es auch möglich, für die Emissionsschicht dasselbe Matrixmaterial zu wählen wie für die Transportschicht eben dieser hochbeweglichen Ladungsträgersorte. Beispielsweise kann im Fall einer Emissionsschicht aus TCTA:Ir(ppy)3 auf einen Elektronenblocker beispielsweise aus Spiro-TAD verzichtet werden, obwohl im Stand der Technik stets solche Strukturen mit Spiro-TAD oder dergleichen angegeben werden, zum Beispiel in He et al.: Appl. Phys. Lett., 85 (17), 3911 (2004). Ebenso können in diesem Falle die Emissionsschicht und die Löchertransportschicht aus dem Matrixmaterial Spiro-TAD bestehen. Dies ist überraschend, da die organische Leuchtdiode vom pin-Typ als solche bereits mehr als zehn Jahre bekannt ist.

Weiterhin wurde die Erkenntnis gewonnen, ein und dasselbe Material als Matrix sowohl die Elektronen- als auch die Löchertransportschicht zu verwenden. Hier stehen die Bedingungen der Dotierbarkeit für beide Ladungsträgersorten einerseits und die Bedingung der geringen Barrieren zur Ladungsträgerinjektion in die Emissionsschicht sowie die Bedingung des Ausschlusses der Exziplexbildung anderseits im Gegensatz. Es wurde erkannt, dass Akzeptor- bzw. Donatorverbindungen ausgewählt werden können, die genügend stark sind, um die Ladungsträgerinjektion in eine rot strahlende Emissionsschicht zu gewährleisten.

Obwohl mittels der beschriebenen Anordnungen organischer Schichten die Gesamtstruktur der OLED signifikant vereinfacht wurde, werden immer noch hocheffiziente Bauteile hergestellt. Ursache hierfür sind die einfache Injektion der Ladungsträger aus den Elektroden in die organische Schichtanordnung und der fast verlustfreie Transport der Ladungsträger durch die Transportschichten aufgrund der Dotierung sowie die effiziente Rekombination in der Emissionszone.

Die in der vorstehenden Beschreibung, der Zeichnung und den Ansprüchen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Anordnung für eine organische Leuchtdiode vom pin-Typ, mit einer Elektrode und einer Gegenelektrode und einem Stapel mit organischen Schichten zwischen der Elektrode und der Gegenelektrode, der Stapel mit organischen Schichten aufweisend:
- eine k (k=1, 2, 3, ...) organische Matrixmaterialien umfassende Emissionsschicht;
- eine dotierte Ladungsträgertransportschicht, die zwischen der Elektrode und der Emissionsschicht angeordnet ist;
- eine weitere dotierte Ladungsträgertransportschicht, die zwischen der Gegenelektrode und der Emissionsschicht angeordnet ist; und
- eine Blockschicht, die zwischen der dotierten Ladungsträgertransportschicht und der Emissionsschicht angeordnet ist;
wobei die organischen Schichten des Stapels mittels n (n ≤ k+2) organischen Matrixmaterialien gebildet sind und die n organischen Matrixmaterialien die k organischen Matrixmaterialien der Emissionsschicht umfassen, **dadurch gekennzeichnet, dass** die dotierte Ladungsträgertransportschicht, die Blockschicht und die weitere dotierte Ladungsträgertransportschicht aus einem ersten organischen Matrixmaterial sind, welches von den n organischen Matrixmaterialien umfasst ist.

2. Anordnung nach Anspruch 1, **gekennzeichnet durch** eine weitere Blockschicht, die zwischen der weiteren dotierten Ladungsträgertransportschicht und der Emissionsschicht angeordnet ist.

3. Anordnung nach Anspruch 2, **dadurch gekennzeichnet, dass** die weitere Blockschicht aus dem ersten organischen Matrixmaterial ist.

4. Anordnung nach einem der vorangehenden Ansprüche, **dadurch gekennzeichnet, dass** die Emissionsschicht mindestens eine Schicht aus dem ersten organischen Matrixmaterial aufweist, die benachbart zu der Blockschicht und / oder der weiteren Blockschicht angeordnet ist.

5. Anordnung nach Anspruch 2 oder Anspruch 4, **dadurch gekennzeichnet, dass** die weitere Blockschicht aus einem zweiten organischen Matrixmaterial ist.

6. Anordnung nach 5, **dadurch gekennzeichnet, dass** die Emissionsschicht mindestens eine Schicht aus dem zweiten organischen Matrixmaterial aufweist, die benachbart zu der weiteren Blockschicht angeordnet ist.

7. Anordnung nach einem der vorangehenden Ansprüche, **dadurch gekennzeichnet, dass** die Emissionsschicht mindestens eine Schicht aus einem dritten organischen Matrixmaterial und / oder mindestens eine Schicht aus einem vierten organischen Matrixmaterial aufweist.

8. Anordnung nach einem der vorangehenden Ansprüche, **dadurch gekennzeichnet, dass** die Emissionsschicht mit zumindest einem Emittermaterial dotiert ist.

9. Anordnung nach Anspruch 8, **dadurch gekennzeichnet, dass** das zumindest eine Emittermaterial fluoreszent ist.

10. Anordnung nach Anspruch 8, **dadurch gekennzeichnet, dass** das zumindest eine Emittermaterial phosphoreszent ist.

11. Anordnung nach einem der vorangehenden Ansprüche, **dadurch gekennzeichnet, dass** die Elektrode und / oder die Gegenelektrode aus einem transparenten Material sind.

12. Anordnung nach einem der vorangehenden Ansprüche, **dadurch gekennzeichnet, dass** der Stapel mit organischen Schichten als eine invertierte Struktur für eine invertierte organische Leuchtdiode vom pin-Typ ausgeführt ist.

13. Anordnung nach einem der Ansprüche 1 bis 11, **dadurch gekennzeichnet, dass** der Stapel mit organischen Schichten als eine nicht-invertierte Struktur für eine nicht-invertierte organische Leuchtdiode vom pin-Typ ausgeführt ist.

14. Organische Leuchtdiode vom pin-Typ mit mindestens einer Anordnung gemäß einem der vorangehenden Ansprüche.

15. Beleuchtungsvorrichtung mit einem lichtemittierenden Element, welches mindestens eine Anordnung gemäß einem der Ansprüche 1 bis 13 umfasst.

16. Selbstleuchtende Anzeigevorrichtung mit einem lichtemittierenden Element, welches mindestens eine Anordnung gemäß einem der Ansprüche 1 bis 13 umfasst.

17. Anzeigevorrichtung, insbesondere Aktiv-Matrix- oder Passiv-Matrix-Anzeige, mit mindestens einer Anordnung gemäß einem der Ansprüche 1 bis 13.

18. Verfahren zum Herstellen eines Stapels mit organischen Schichten für eine organische Leuchtdiode vom pin-Typ nach einem der Ansprüche 1 bis 13, wobei ein organisches Matrixmaterial mit Hilfe einer Abscheidungsvorrichtung prozessiert wird und das organische Matrixmaterial für mehrere der organischen Schichten des Stapels verwendet wird, **dadurch gekennzeichnet, dass** die mehreren organischen Schichten des Stapels mittels Abscheiden des organischen Matrixmaterials gebildet werden, indem das organische Matrixmaterial aus einer einzelnen Verdampfungsquelle verdampft wird, welche von der Abscheidungsvorrichtung umfasst ist.

19. Verfahren nach Anspruch 18, **dadurch gekennzeichnet, dass** die mehreren organischen Schichten des Stapels mittels Abscheiden des ersten organischen Matrixmaterials gebildet werden, indem zumindest ein Teil der mehreren organischen Schichten in einer durchgehenden Matrix aus dem ersten organischen Matrixmaterial in dem Stapel gebildet wird.

20. Verfahren nach Anspruch 19, **dadurch gekennzeichnet, dass** beim Bilden der durchgehenden Matrix aus dem ersten organischen Matrixmaterial in einem Zwischenschritt eine dotierte Ladungsträgernansportschicht mittels Co-Verdampfung eines Dotierungsmaterials und / oder eine Blockschicht und / oder eine Emissionsschicht mittels Co-Verdampfung eines Emittermaterials und / oder eine weitere Blockschicht und / oder eine weitere dotierte Ladungsträgertransportschicht mittels Co-Verdampfung eines weiteren Dotierungsmaterials gebildet werden.

## Claims

1. Arrangement for an organic pin-type light-emitting diode with an electrode and a counter-electrode and a stack with organic layers between the electrode and the counter-electrode, where the stack with the organic layers comprises an emission layer comprising k (k=1, 2, 3, ...) organic matrix materials, a doped charge carrier transport layer, which is arranged between the electrode and the emission layer, an additional doped charge carrier transport layer, which is arranged between the counter-electrode and the emission layer, and a block layer, which is arranged between the doped charge carrier transport layer and the emission layer, wherein the organic layers of the stack are formed by means of n (n ≤ k+2) organic matrix materials, where the n organic matrix materials comprise the k organic matrix materials of the emission layer, **characterized in that** the doped charge carrier transport layer, the block layer and the additional doped charge carrier transport layer are made from a first organic matrix material, which is comprised by the n organic matrix materials.

2. Arrangement according to Claim 1, **characterized by** an additional block layer, which is arranged between the additional doped charge carrier transport layer and the emission layer.

3. Arrangement according to Claim 2, **characterized in that** the additional block layer is made from the first organic matrix material.

4. Arrangement according to any one of the previous Claims, **characterized in that** the emission layer has at least one layer from the first organic matrix material, which is arranged close to the block layer and/or to the additional block layer.

5. Arrangement according to Claim 2 or Claim 4, **characterized in that** the additional block layer is made from a second organic matrix material.

6. Arrangement according to Claim 5, **characterized in that** the emission layer has at least one layer from the second organic matrix material, which is arranged close to the additional block layer.

7. Arrangement according to any one of the previous Claims, **characterized in that** the emission layer has at least one layer from the third organic matrix material and/or at least one layer from the fourth organic matrix material.

8. Arrangement according to any one of the previous Claims, **characterized in that** the emission layer is doped with at least one emitter material.

9. Arrangement according to Claim 8, **characterized in that** at least one emitter material is fluorescent.

10. Arrangement according to Claim 8, **characterized in that** at least one emitter material is phosphorescent.

11. Arrangement according to any one of the previous Claims, **characterized in that** the electrode and/or the counter-electrode are made from a transparent material.

12. Arrangement according to any one of the previous Claims, **characterized in that** the stack and/or the block-layer-free stack with the organic layers is executed as an inverted structure for an inverted organic pin-type light-emitting diode.

13. Arrangement according to any one of the Claims 1 to 11, **characterized in that** the stack and/or the block-layer-free stack with the organic layers is executed as a non-inverted structure for a non-inverted organic pin-type light-emitting diode.

14. Organic pin-type light-emitting diode with at least one arrangement according to any one of the previous Claims.

15. Lighting device with a light-emitting element, which comprises at least one arrangement according to any one of the Claims 1 to 13.

16. Self-lighting display device with a light-emitting element, which has at least one arrangement according to any one of the Claims 1 to 13.

17. Display device, particularly an active matrix display or a passive matrix display, with at least one arrangement according to any one of the Claims 1 to 13.

18. Method for manufacturing a stack with organic layers for an organic pin-type light-emitting diode according to any one of the Claims 1 to 13, wherein a first organic matrix material is processed with the help of a separating device and the organic matrix material is used for several organic layers of the stack **characterized in that** the plurality of organic layers of the stack is formed by means of separation of the first organic matrix material, with the first organic matrix material being evaporated from a single evaporation source, which is comprised by the separating device.

19. Method according to Claim 18, **characterized in that** the plurality of the organic layers is formed by means of separation of the first organic matrix material, with at least a part of the plurality of layers in a continuous matrix being formed from the first organic matrix material in the stack.

20. Method according to Claim 19, **characterized in that**, during the formation of the continuous matrix from the first organic matrix material, in an intermediate step, a doped charge carrier transport layer is formed by means of co-evaporation of a doping material and/or a block layer is formed and/or an emission layer is formed by means of co-evaporation of an emitter material and/or an additional block layer is formed and/or an additional doped charge carrier transport layer is formed by means of co-evaporation of an additional doping material.

## Revendications

1. Ensemble pour une diode électroluminescente organique du type PIN comprenant une électrode et une contre-électrode et une pile comprenant des couches organiques entre l'électrode et la contre-électrode, la pile comprenant des couches organiques présentant :
- une couche d'émission comprenant k (k = 1, 2, 3, ...) matériaux de matrice organiques ;
- une couche de transport de porteurs de charge dopée qui est disposée entre l'électrode et la couche d'émission ;
- une couche de transport de porteurs de charge dopée supplémentaire qui est disposée entre la contre-électrode et la couche d'émission ; et
- une couche en bloc qui est disposée entre la couche de transport de porteurs de charge dopée et la couche d'émissions ;
les couches organiques de la pile étant formées au moyen de n (n ≤ k+2) matériaux de matrice organiques et les n matériaux de matrice organiques comprenant les k matériaux de matrice organiques, **caractérisé en ce que** la couche de transport de porteurs de charge dopée, la couche en bloc et la couche de transport de porteurs de charge dopée supplémentaire sont constituées d'un premier matériau de matrice organique qui est compris dans les n matériaux de matrice organiques.

2. Ensemble selon la revendication 1, **caractérisé par** une couche en bloc supplémentaire qui est disposée entre la couche de transport de porteurs de charge dopée supplémentaire et la couche d'émission.

3. Ensemble selon la revendication 2, **caractérisé en ce que** la couche en bloc supplémentaire est constituée du premier matériau de matrice organique.

4. Ensemble selon l'une quelconque des revendications précédentes, **caractérisé en ce que** la couche d'émission présente au moins une couche constituée du premier matériau de matrice organique qui est disposée de manière à être adjacente à la couche en bloc et /ou à la couche en bloc supplémentaire.

5. Ensemble selon la revendication 2 ou la revendication 4, **caractérisé en ce que** la couche en bloc supplémentaire est constituée d'un deuxième matériau de matrice organique.

6. Ensemble selon la revendication 5, **caractérisé en ce que** la couche d'émission présente au moins une couche constituée du deuxième matériau de matrice organique, couche qui est disposée de manière à être adjacente à la couche en bloc supplémentaire.

7. Ensemble selon l'une quelconque des revendications précédentes, **caractérisé en ce que** la couche d'émission présente au moins une couche constituée d'un troisième matériau de matrice organique et / ou au moins une couche constituée d'un quatrième matériau de matrice organique.

8. Ensemble selon l'une quelconque des revendications précédentes, **caractérisé en ce que** la couche d'émission est dopée avec au moins un matériau émetteur.

9. Ensemble selon la revendication 8, **caractérisé en ce que** le ou les matériaux émetteur sont fluorescents.

10. Ensemble selon la revendication 8, **caractérisé en ce que** le ou les matériaux émetteurs sont phosphorescents.

11. Ensemble selon l'une quelconque des revendications précédentes, **caractérisé en ce que** l'électrode et / ou la contre-électrode est (sont) constituée(s) d'un matériau transparent.

12. Ensemble selon l'une quelconque des revendications précédentes, **caractérisé en ce que** la pile comprenant des couches organiques est réalisée comme structure inversée pour une diode électroluminescente organique inversée du type PIN.

13. Ensemble selon l'une quelconque des revendications 1 à 11, **caractérisé en ce que** la pile comprenant des couches organiques est réalisée comme structure non inversée pour une diode électroluminescente organique non inversée du type PIN.

14. Diode électroluminescente organique du type PIN comprenant au moins un ensemble selon l'une quelconque des revendications précédentes.

15. Dispositif d'éclairage muni d'un élément électroluminescent qui comprend au moins un ensemble selon l'une quelconque des revendications 1 à 13.

16. Dispositif d'affichage autolumineux muni d'un élément électroluminescent qui comprend au moins un ensemble selon l'une quelconque des revendications 1 à 13.

17. Dispositif d'affichage, notamment affichage à matrice active ou affichage à matrice passive, muni d'au moins un ensemble selon l'une quelconque des revendications 1 à 13.

18. Procédé de fabrication d'une pile comprenant des couches organiques pour une diode électroluminescente organique du type PIN selon l'une quelconque des revendications 1 à 13, un matériau de matrice organique étant réalisé à l'aide d'un dispositif de séparation et le matériau de matrice organique étant utilisé pour plusieurs couches des couches organiques de la pile, **caractérisé en ce que** la pluralité de couches organiques de la pile sont constituées par séparation du matériau de matrice organique par vaporisation du matériau de matrice organique à partir d'une seule et unique source de vaporisation qui est comprise dans le dispositif de séparation.

19. Procédé selon la revendication 18, **caractérisé en ce que** la pluralité de couches organiques de la pile sont constituées par séparation du premier matériau de matrice organique en formant au moins une partie de la pluralité de couches organiques dans une matrice continue à partir du premier matériau de matrice organique dans la pile.

20. Procédé selon la revendication 19, **caractérisé en ce que,** lors de la formation de la matrice continue à partir du premier matériau de matrice organique, une couche de transport de porteurs de charge dopée est constituée dans une étape intermédiaire par co-vaporisation d'un matériau de dopage et / ou une couche en bloc et / ou une couche d'émission est constituée par co-vaporisation d'un matériau émetteur et / ou une couche en bloc supplémentaire et / ou une couche de transport de porteurs de charge dopée supplémentaire est constituée par co-vaporisation d'un matériau de dopage supplémentaire.
